# EUROPÄISCHE PATENTSCHRIFT

(11) **EP 3 647 704 B1**
(45) Veröffentlichungstag und Bekanntmachung des Hinweises auf die Patenterteilung: **26.05.2021**
(21) Anmeldenummer: 19205322.1
(22) Anmeldetag: 25.10.2019
(51) Int. Cl.: F28D 1/04, F28D 1/03, H01M 10/625, H01M 10/613, H01M 10/6556, F28D 21/00, F28D 1/053

(54) **VORRICHTUNG ZUR WÄRMEÜBERTRAGUNG ZUM TEMPERIEREN VON BATTERIEN UND BAUTEILEN DER LEISTUNGSELEKTRONIK**
HEAT TRANSFER DEVICE FOR HEATING BATTERIES AND COMPONENTS OF THE POWER ELECTRONICS
DISPOSITIF DE TRANSFERT DE CHALEUR DESTINÉ À LA MISE EN TEMPÉRATURE DES BATTERIES ET DES COMPOSANTS DE L'ÉLECTRONIQUE DE PUISSANCE

(30) Priorität: 30.10.2018 DE 102018127017
(43) Veröffentlichungstag der Anmeldung: 06.05.2020
(73) Patentinhaber: Hanon Systems, Daejeon 34325 (KR)
(72) Erfinder: Girmscheid, Felix, 50676 Köln (DE); Schoemaker, Gero, 50999 Köln (DE); Mielenhausen, Mario, 50226 Frechen (DE)
(74) Vertreter: Hoffmann Eitle

(56) Entgegenhaltungen:
- WO-A1-2016/168932
- DE-A1-102012 217 869
- FR-A1- 2 898 405
- US-A1- 2015 236 385

## Beschreibung

Die Erfindung betrifft eine Vorrichtung zur Wärmeübertragung zum Temperieren von Batterien und Bauteilen der Leistungselektronik. Die Erfindung eignet sich insbesondere zum Temperieren einer Batterie und Komponenten der Leistungselektronik eines Elektrofahrzeuges oder eines Hybridfahrzeuges.

Der Trend zur Elektrifizierung des Antriebsstrangs von Fahrzeugen stellt die Entwickler vor neue Herausforderungen. So werden für die Kühlung von Batterien, wie Lithium-Ionen-Batterien, und die dazugehörige Leistungselektronik von Hybridfahrzeugen und Elektrofahrzeugen Temperaturen unterhalb von 40 °C gefordert. Um dies auch bei einem Fahrzeugstillstand zu erreichen, ist eine aktive Temperierung erforderlich. Bislang werden zum Temperieren von Batteriezellen oder Elektronikkomponenten Wärmeübertrager mit ebener Kühlfläche eingesetzt. Die Wärmeübertrager sind üblicherweise mit fluidführenden Kanälen gebildet, wobei zwischen den fluidführenden Kanälen Turbulatoren oder Lamellen integriert sind, um einen guten Wärmeübergang und eine Verwindungssteifigkeit zu gewährleisten. Die Turbulatoren werden vorzugsweise eingesetzt, um das Kühlmittel möglichst gleichmäßig in einem Strömungskanal zu verteilen. Dennoch kommt es bei den bisher bekannten Vorrichtungen zum Temperieren von Batterien und Bauteilen der Leistungselektronik entlang der fluidführenden Kanäle zu einem Aufheizen des in den Kanälen geführten Fluids, was einen vergleichsweise hohen Temperaturgradienten des Fluids zwischen dem Einlass und dem Auslass eines Wärmeübertragers zur Folge hat. Da insbesondere die Kühlleistung des Fluids in Richtung des Auslasses des Wärmeübertragers und damit entlang der Wärmeübertragungsfläche geringer wird, kann es zu Schäden an den Batterien und den Elektronikbauteilen kommen. Aus diesem Grund wird eine Möglichkeit zur Verringerung des Temperaturgradienten eines Fluids entlang der Wärmeübertragungsfläche einer Batterie oder eines Bauteils der Leistungselektronik gefordert. Die DE 10 2012 217869 A1 offenbart Merkmale, die unter den Oberbegriff des Anspruchs 1 fallen. US 2015/236385 A1, FR 2 898 405 A1 und WO 2016/168932 A1 sind weiterer Stand der Technik.

Aufgabe der Erfindung ist es, eine Vorrichtung zur Wärmeübertragung zum Temperieren speziell von Batterien und Bauteilen der Leistungselektronik, insbesondere zum Temperieren einer Batterie und Komponenten der Leistungselektronik eines Elektrofahrzeuges oder eines Hybridfahrzeuges, bereitzustellen, mit welcher ein Temperaturgradient eines Wärmeträgerfluids entlang einer Wärmeübertragungsfläche verringert werden kann.

Die Aufgabe wird durch eine Vorrichtung zur Wärmeübertragung mit den Merkmalen gemäß Patentanspruch 1 gelöst. Weiterbildungen und Ausführungsvarianten sind in den abhängigen Patentansprüchen angegeben.

Die Aufgabe wird durch eine erfindungsgemäße Vorrichtung zur Wärmeübertragung zum Temperieren von Batterien und Bauteilen der Leistungselektronik, insbesondere für ein Elektrofahrzeug oder ein Hybridfahrzeug, gelöst. Die Vorrichtung weist einen Einlass und einen Auslass für das Fluid sowie mindestens zwei fluidführende plattenförmige Wärmeübertragerelemente auf. Dabei sind ein erstes plattenförmiges Wärmeübertragerelement und ein zweites plattenförmiges Wärmeübertragerelement zur Wärmeübertragung flächig miteinander derart kontaktiert angeordnet, dass über die gesamte Kontaktfläche Wärme übertragen wird. Das zweite plattenförmige Wärmeübertragerelement ist zudem zur flächigen Kontaktierung mit einer Wärmeübertragungsfläche einer Batterie, einer Batteriezelle und/oder eines Bauteils einer Leistungselektronik ausgebildet. Das zweite plattenförmige Wärmeübertragerelement ist vorteilhaft zwischen dem ersten plattenförmigen Wärmeübertragerelement und der Batterie, der Batteriezelle und/oder dem Bauteil einer Leistungselektronik angeordnet.

Zwischen dem ersten plattenförmigen Wärmeübertragerelement und dem zweiten plattenförmigen Wärmeübertragerelement ist mindestens eine Fluidverbindung ausgebildet, sodass das zweite plattenförmige Wärmeübertragerelement mit dem aus dem ersten plattenförmigen Wärmeübertragerelement austretenden Fluid durchströmbar ist.

Nach einer Weiterbildung der Erfindung sind der Einlass für das Fluid an dem ersten plattenförmigen Wärmeübertragerelement und der Auslass für das Fluid an dem zweiten plattenförmigen Wärmeübertragerelement ausgebildet. Dabei ist der Einlass des Fluids in das erste plattenförmige Wärmeübertragerelement vorteilhaft durch das zweite plattenförmige Wärmeübertragerelement hindurchführend angeordnet.

Das über den Einlass zuführbare Fluid durchströmt damit zunächst das erste plattenförmige Wärmeübertragerelement, bevor das Fluid in das zweite plattenförmige Wärmeübertragerelement gelangt, welches direkt mit einer Wärmeübertragungsfläche der Batterie, der Batteriezelle und/oder des Bauteils einer Leistungselektronik kontaktiert ist.

Wärme, welche von der Wärmeübertragungsfläche der Batterie, der Batteriezelle und/oder des Bauteils einer Leistungselektronik an das im zweiten Wärmeübertragerelement strömende Fluid übertragen wird, ist somit zumindest teilweise auf das im ersten Wärmeübertragerelement strömende Fluid übertragbar. Damit wird die Temperaturdifferenz des durch die Vorrichtung strömenden Fluids entlang der Wärmeübertragungsfläche im zweiten plattenförmigen Wärmeübertragerelement gering gehalten, sodass eine gleichmäßigere Temperierleistung erzielt werden kann.

Unter dem Begriff Temperieren ist im Sinne der Erfindung ein Kühlen oder ein Erwärmen zu verstehen. Damit kann die erfindungsgemäße Vorrichtung bei hohen Außentemperaturen zum gleichmäßigen Kühlen der Batterie, der Batteriezelle und/oder des Bauteils einer Leistungselektronik eingesetzt werden. Weiterhin besteht die Möglichkeit, die erfindungsgemäße Vorrichtung zum Erwärmen der Batterie, der Batteriezelle und/oder des Bauteils einer Leistungselektronik einzusetzen, um bei geringen Außentemperaturen eine gewünschte Betriebstemperatur der Batterie, der Batteriezelle und/oder des Bauteils einer Leistungselektronik zu gewährleisten.

Nach einer bevorzugten Ausgestaltung der Erfindung sind der Einlass des Fluids und der Auslass des Fluids auf einer gemeinsamen Seite und damit auf der selben Seite der Vorrichtung angeordnet oder der Einlass des Fluids und der Auslass des Fluids sind zumindest in einer räumlichen Nähe zueinander derart angeordnet, dass eine hohe Temperatur des Fluids am Auslass über die Kontaktfläche zwischen dem ersten und dem zweiten Wärmeübertragerelement an das am Einlass des gegenüberliegenden ersten Wärmeübertragerelements niedertemperierte Fluid übertragbar und ableitbar ist. Dadurch wird das Fluid am Auslass stärker abgekühlt, sodass vorteilhafterweise ein geringerer Temperaturgradient entlang der Wärmeübertragungsfläche der Batterie, der Batteriezelle und/oder des Bauteils einer Leistungselektronik erreicht wird.

Nach der Erfindung sind das erste plattenförmige Wärmeübertragerelement und das zweite plattenförmige Wärmeübertragerelement aus drei profilierten Platten ausgebildet, welche flächig zueinander angeordnet und zumindest randseitig fluiddicht miteinander verbunden sind. Dabei bilden die Profilierungen der Platten zwischen den Platten Hohlräume als Fluidführungen aus. Unter dem Begriff Fluidführung ist ein fluidführender Kanal zu verstehen, welcher jeweils im Inneren der plattenförmigen Wärmeübertragerelemente ausgebildet ist. Besonders platzsparend können der Einlass, der Auslass und die mindestens eine Fluidverbindung zwischen den plattenförmigen Wärmeübertragerelementen mittels Durchgangsöffnungen in den Platten ausgebildet sein.

Ein Vorteil der Erfindung besteht darin, dass das erste plattenförmige Wärmeübertragerelement aus einer ersten Platte und einer zweiten Platte sowie das zweite plattenförmige Wärmeübertragerelement aus der zweiten Platte und einer dritten Platte ausgebildet sind. Damit stellt die zweite Platte eine Verbindung und eine Wärmeübertragerfläche zwischen den plattenförmigen Wärmeübertragerelementen dar.

Nach einer ersten alternativen nicht erfindungsgemäßen Ausgestaltung sind die Fluidverbindung zwischen den flächig kontaktierten plattenförmigen Wärmeübertragerelementen und/oder Fluidführungen innerhalb der flächig kontaktierten plattenförmigen Wärmeübertragerelemente derart ausgebildet, dass das Fluid innerhalb der Fluidführung des ersten plattenförmigen Wärmeübertragerelements gegenüber der Fluidführung im zweiten plattenförmigen Wärmeübertragerelement im Gegenstrom geleitet wird.

Die Fluidführungen im ersten plattenförmigen Wärmeübertragerelement und im zweiten Wärmeübertragerelement können jeweils mit einem einzigen Kanal ausgebildet sein, welcher sich über den gesamten inneren Querschnitt des jeweiligen Wärmeübertragerelements erstreckt.

Nach der Erfindung sind die Fluidverbindung zwischen den flächig kontaktierten plattenförmigen Wärmeübertragerelementen und/oder Fluidführungen innerhalb der flächig kontaktierten plattenförmigen Wärmeübertragerelemente derart ausgebildet, dass das Fluid innerhalb der Fluidführung des ersten plattenförmigen Wärmeübertragerelements gegenüber der Fluidführung im zweiten plattenförmigen Wärmeübertragerelement im Gleichstrom geleitet wird. Es hat sich gezeigt, dass bei der Ausgestaltung der Vorrichtung mit Gleichstrom der Fluidführungen ein sehr geringer und konstanter Temperaturgradient zwischen dem ersten plattenförmigen Wärmeübertragerelement und dem zweiten plattenförmigen Wärmeübertragerelement erreicht wird.

Die Fluidführungen innerhalb des ersten plattenförmigen Wärmeübertragerelements und innerhalb des zweiten plattenförmigen Wärmeübertragerelements können jeweils als ein Kanal ausgebildet sein, welcher eine U-Form aufweist.

Die mindestens eine Fluidverbindung zwischen dem ersten plattenförmigen Wärmeübertragerelement und dem zweiten plattenförmigen Wärmeübertragerelement ist vorteilhaft platzsparend innerhalb der gemeinsamen Kontaktfläche angeordnet. Die Fluidverbindung ist vorzugsweise am äußeren Rand der flächig aneinanderliegenden plattenförmigen Wärmeübertragerelemente ausgebildet, um eine größtmögliche Wärmeübertragungsfläche zwischen dem ersten plattenförmigen Wärmeübertragerelement und dem zweiten plattenförmigen Wärmeübertragerelement zu gewährleisten.

Die mindestens eine Fluidverbindung zwischen den flächig kontaktierten plattenförmigen Wärmeübertragerelementen ist vorzugsweise in der Form eines Schlitzes auf den jeweils zugewandten Seiten zwischen den flächig kontaktierten plattenförmigen Wärmeübertragerelementen ausgebildet. Der Schlitz erstreckt sich dabei vorteilhaft über die gesamte Breite der jeweiligen Fluidführungen. Das Fluid gelangt folglich über die gesamte Breite des Kanals aus dem ersten plattenförmigen Wärmeübertragerelement in das zweite plattenförmige Wärmeübertragerelement. Innerhalb des Schlitzes als Verbindung der Fluidführungen innerhalb des ersten und des zweiten plattenförmigen Wärmeübertragerelements kann mindestens ein Drosselelement angeordnet sein, um eine Fluidströmung über die Breite der Fluidführung gleichmäßig zu verteilen. Das Drosselelement dient dem Beeinflussen der Fluidströmung und kann mit Durchgangsöffnungen in Form von beispielsweise gestanzten Rundlöchern, Langlöchern, ovalen Löchern oder Schlitzen ausgebildet sein. Ferner kann das Drosselelement als ein Einsatzelement, wie ein Lochblech, Lamellen oder ein Riffelblech mit Schlitzen ausgebildet sein. Das Drosselelement kann ebenso durch Fräsen und/oder Drehen hergestellt sein.

Nach einer alternativen Ausgestaltung der Erfindung ist die mindestens eine Fluidverbindung zwischen dem ersten plattenförmigen Wärmeübertragerelement und dem zweiten plattenförmigen Wärmeübertragerelement als eine zusätzliche Verbindungsleitung ausgebildet, wobei die Anschlüsse für die Verbindungsleitung vorzugsweise am Rand der plattenförmigen Wärmeübertragerelemente orthogonal zur Kontaktfläche zwischen dem ersten plattenförmigen Wärmeübertragerelement und dem zweiten plattenförmigen Wärmeübertragerelement angeordnet sind.

Nach einer weiteren Ausgestaltung der Erfindung sind über die gemeinsame Kontaktfläche zwischen dem ersten plattenförmigen Wärmeübertragerelement und dem zweiten plattenförmigen Wärmeübertragerelement mehrere Fluidverbindungen verteilt derart angeordnet, dass das Fluid aus dem ersten plattenförmigen Wärmeübertragerelement punktuell in das zweite plattenförmige Wärmeübertragerelement überströmt. Die mehreren verteilt angeordneten Fluidverbindungen erweisen sich insbesondere dann als vorteilhaft, wenn im Bereich der Wärmeübergangsfläche des zweiten plattenförmigen Wärmeübertragerelements zur Batterie, zur Batteriezelle und/oder zum Bauteil einer Leistungselektronik Temperaturspitzen auftreten, da solche Temperaturspitzen infolge des lokal in das zweite plattenförmige Wärmeübertragerelement einströmenden niedertemperierten Fluids kompensierbar sind.

Um den Temperaturgradienten im ersten plattenförmigen Wärmeübertragerelement vom Einlass des Fluids bis zur Fluidverbindung möglichst gering zu halten und im ersten plattenförmigen Wärmeübertragerelement eine gleichmäßige Verteilung des Fluids zu gewährleisten, kann die Fluidführung im ersten plattenförmigen Wärmeübertragerelement mit Turbulatoren und/oder Leitelementen ausgebildet sein.

Zudem kann die Fluidführung im zweiten plattenförmigen Wärmeübertragerelement Turbulatoren und/oder Leitelemente aufweisen, um auch den Temperaturgradienten im zweiten plattenförmigen Wärmeübertragerelement von der Fluidverbindung bis zum Auslass des Fluids möglichst gering zu halten und im zweiten plattenförmigen Wärmeübertragerelement eine gleichmäßige Verteilung des Fluids zu gewährleisten.

Eine Verbindung der Vorrichtung, insbesondere des zweiten plattenförmigen Wärmeübertragerelements mit der Wärmeübertragungsfläche der Batterie und/oder des Bauteils einer Leistungselektronik kann durch Kleben, Verpressen, Löten oder Sintern realisiert sein.

Der Einlass und der Auslass für das Fluid können an einer Kontaktseite mit der Wärmeübertragungsfläche einer Batterie und/oder eines Bauteils einer Leistungselektronik an dem zweiten plattenförmigen Wärmeübertragerelement angeordnet sein. Der Einlass und der Auslass sind vorteilhaft randseitig ausgebildet, sodass in den Flächen der plattenförmigen Wärmeübertragerelemente keine nach außen führenden Durchbrechungen erforderlich sind. Nach einer alternativen Ausgestaltung sind der Einlass und der Auslass für das Fluid an einer von der Wärmeübertragungsfläche einer Batterie und/oder eines Bauteils einer Leistungselektronik abgewandten Seite an dem ersten plattenförmigen Wärmeübertragerelement angeordnet.

Nach einer weiteren bevorzugten Ausgestaltung der Erfindung ist das erste plattenförmige Wärmeübertragerelement oder das zweite plattenförmige Wärmeübertragerelement zur flächigen Kontaktierung mit einer Wärmeübertragungsfläche einer Batterie, einer Batteriezelle und/oder eines Bauteils einer Leistungselektronik ausgebildet. Damit kann die Außenfläche des ersten plattenförmigen Wärmeübertragerelements oder die Außenfläche des zweiten plattenförmigen Wärmeübertragerelements mit einer Wärmeübertragungsfläche einer Batterie, einer Batteriezelle und/oder eines Bauteils einer Leistungselektronik kontaktiert werden, wobei die Strömungsrichtung des Fluids entsprechend anzupassen ist.

Die in dem ersten plattenförmigen Wärmeübertragerelement und in dem zweiten plattenförmigen Wärmeübertragerelement jeweils ausgebildeten Fluidführungen können als ein Kanal ausgebildet sein, welcher eine Zick-Zack-Form oder eine Doppel-U-Form aufweist.

Nach einer weiteren nicht erfindungsgemäßen Ausgestaltung sind die mindestens zwei fluidführenden plattenförmigen Wärmeübertragerelemente jeweils mit mindestens zwei Flachrohren ausgebildet, wobei Flachrohre des ersten plattenförmigen Wärmeübertragerelements und Flachrohre des zweiten plattenförmigen Wärmeübertragerelements zur Wärmeübertagung flächig miteinander kontaktiert sind. An den Enden sind die Flachrohre derart miteinander verbunden, dass die Flachrohre des zweiten plattenförmigen Wärmeübertragerelements mit dem aus den Flachrohren des ersten plattenförmigen Wärmeübertragerelements austretenden Fluid durchströmbar sind. Dabei können die endständigen Verbindungen zwischen den Flachrohren mittels Sammlern derart ausgebildet sein, dass die Flachrohre im Gegenstrom durchströmbar sind. Weiterhin kann es vorgesehen sein, dass die mindestens zwei fluidführenden plattenförmigen Wärmeübertragerelemente jeweils mit mindestens einem weiteren Flachrohr erweiterbar sind, wobei in den endständigen Sammlern, welche die Flachrohre miteinander verbinden, Trennelemente angeordnet sind, welche eine Strömung in eine gewünschte Richtung ermöglichen. Auf diese Weise können verschiedene Strömungspfade der Fluidführung realisiert werden.

Es hat sich gezeigt, das mit der erfindungsgemäßen Vorrichtung bei gleichbleibender Fluidströmung eine Reduzierung des Temperaturgradienten entlang der Wärmeübertragungsfläche der Batterie, der Batteriezelle und/oder des Bauteils einer Leistungselektronik erreicht werden kann. Wenn eine Verringerung des Temperaturgradienten entlang der Wärmeübertragungsfläche der Batterie, der Batteriezelle und/oder des Bauteils einer Leistungselektronik nicht erforderlich ist, kann mit der erfindungsgemäßen Vorrichtung eine gleichbleibende Temperierleistung bei verringerter Fluidströmung erreicht werden, wodurch in bestehenden Systemen Energie eingespart werden kann. Bei Neukonzeptionen können kleinere Pumpen zur Förderung des Fluids vorgesehen werden. Die erfindungsgemäße Vorrichtung ist vorteilhaft auf einfache Weise in ein bestehendes Temperiersystem integrierbar, in welchem der Einlass und der Auslass mit den fluidführenden Leitungen des bestehenden Temperiersystems entsprechend der Strömungsrichtung des geförderten Fluids verbunden werden.

Weitere Einzelheiten, Merkmale und Vorteile von Ausgestaltungen der Erfindung ergeben sich aus der nachfolgenden Beschreibung von Ausführungsbeispielen mit Bezugnahme auf die zugehörigen Zeichnungen. Es zeigen:
- Figur 1:: eine schematische Darstellung einer nach dem Stand der Technik bekannten Vorrichtung zur Wärmeübertragung zum Temperieren einer Batterie sowie ein Temperaturverlaufsdiagramm A,
- Figur 2:: eine schematische Darstellung einer Vorrichtung zur Wärmeübertragung zum Temperieren einer Batterie mit einem Temperaturverlaufsdiagramm B und
- Figur 3:: die Vorrichtung aus Figur 2 in einer Explosionsdarstellung,
- Figur 4a:: eine schematische Explosionsdarstellung eines Ausführungsbeispiels der Vorrichtung zur Wärmeübertragung,
- Figur 4b:: eine schematische Schnittdarstellung des Ausführungsbeispiels der Vorrichtung zur Wärmeübertragung aus Figur 4a im zusammengesetzten Zustand,
- Figur 5:: eine schematische Explosionsdarstellung einer Vorrichtung zur Wärmeübertragung,
- Figur 6:: eine schematische Schnittdarstellung einer Anordnung der Anschlüsse für das Fluid,
- Figur 7:: eine schematische Explosionsdarstellung einer Vorrichtung zur Wärmeübertragung,
- Figur 8:: eine schematische Explosionsdarstellung eines fünften Ausführungsbeispiels der Vorrichtung zur Wärmeübertragung,
- Figur 9:: eine schematische Explosionsdarstellung einer Vorrichtung zur Wärmeübertragung,
- Figur 10:: eine schematische Darstellung einer Seitenansicht der Vorrichtung zur Wärmeübertragung aus Figur 9 im zusammengesetzten Zustand,
- Figur 11:: eine perspektivische Darstellung des in Figur 10 Beispiels der Vorrichtung zur Wärmeübertragung sowie
- Figur 12: eine schematische Explosionsdarstellung einer Weiterbildung des Beispiels der Vorrichtung zur Wärmeübertragung.

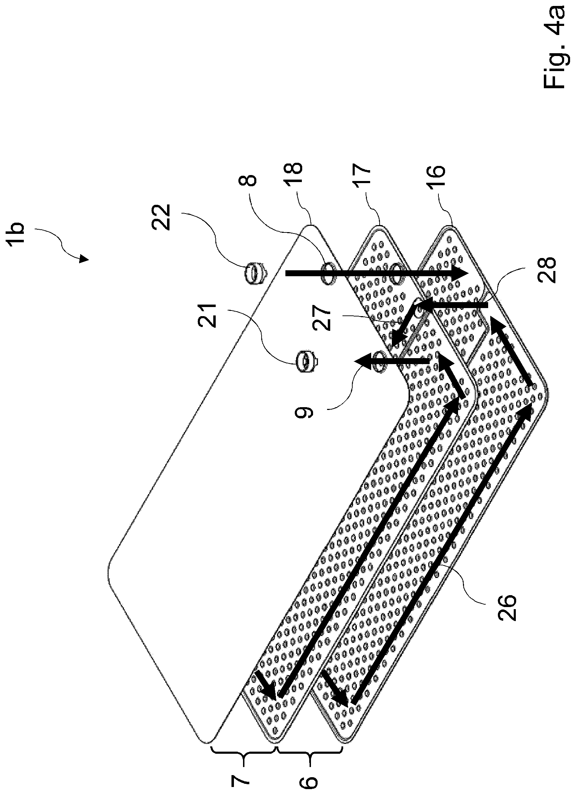

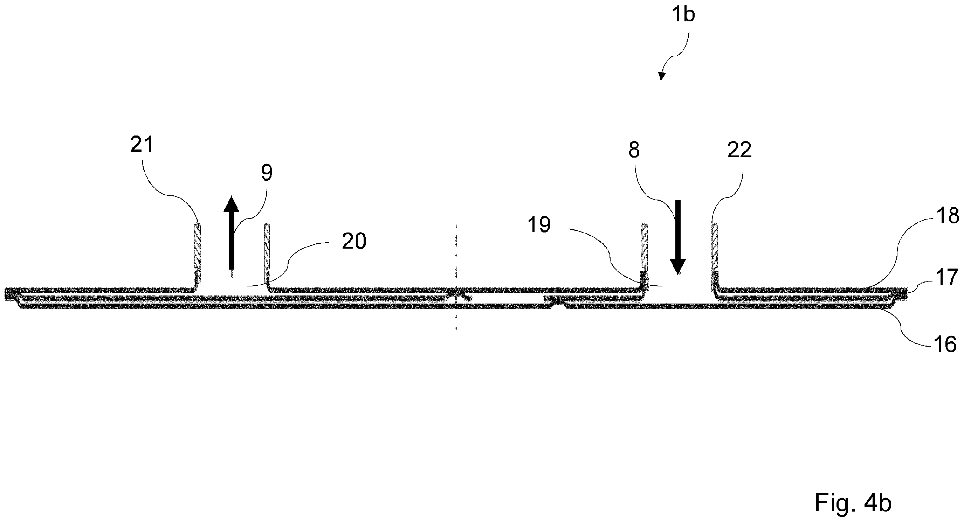

Nur Fig. 4a und Fig. 4b offenbaren ein Ausführungsbeispiel gemäß der Erfindung. Die anderen Abbildungen zeigen lediglich Beispiele, die zum Verständnis der Erfindung nützlich sind.

Wiederkehrende Merkmale sind in den Figuren mit gleichen Bezugszeicher versehen.

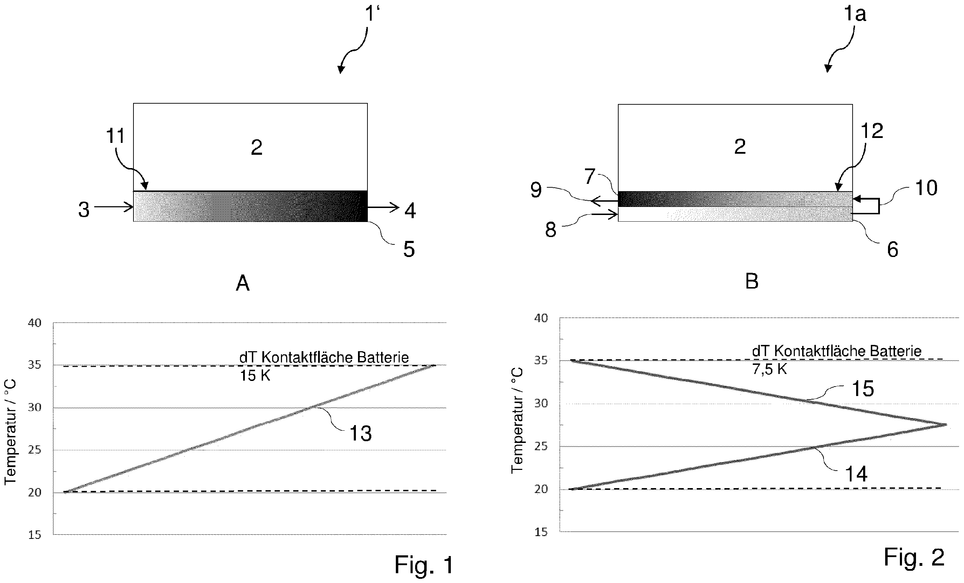

Figur 1 zeigt eine schematische Darstellung einer nach dem Stand der Technik bekannten Vorrichtung 1' zur Wärmeübertragung zum Temperieren einer Batterie 2 mit einem plattenförmigen Wärmeübertrager 5 mit einem Einlass 3 für ein Fluid und einem Auslass 4 für das Fluid. Die Pfeile verdeutlichen die Strömungsrichtung des Fluids.

Der im Temperaturverlaufsdiagramm A dargestellte Anstieg 13 entspricht dem Temperaturanstieg entlang der Wärmeübertragungsfläche 11 zwischen der Batterie 2 und dem Wärmeübertrager 5. Die Temperaturdifferenz des Fluids zwischen dem Einlass 3 und dem Auslass 4 beträgt 15 K.

Figur 2 zeigt eine schematische Darstellung einer Vorrichtung 1a zur Wärmeübertragung zum Temperieren einer Batterie 2 mit einem Temperaturverlaufsdiagramm B. Im Unterschied zur Vorrichtung 1' aus Figur 1 weist die Vorrichtung 1a zwei fluidführende plattenförmige Wärmeübertragerelemente 6, 7 auf, von denen ein erstes plattenförmiges Wärmeübertragerelement 6 und ein zweites plattenförmiges Wärmeübertragerelement 7 zur Wärmeübertragung flächig miteinander kontaktiert sind, wobei das zweite plattenförmige Wärmeübertragerelement 7 zur flächigen Kontaktierung mit einer Wärmeübertragungsfläche 12 der Batterie 2 ausgebildet ist. Ferner kann das zweite plattenförmige Wärmeübertragerelement 7 auch zur flächigen Kontaktierung mit einer Wärmeübertragungsfläche eines Bauteils einer Leistungselektronik ausgebildet sein. An dem ersten plattenförmigen Wärmeübertragerelement 6 ist ein Einlass 8 für das Fluid vorgesehen. Ein Auslass 9 für das Fluid ist an dem zweiten plattenförmigen Wärmeübertragerelement 7 ausgebildet, wobei zwischen dem ersten plattenförmigen Wärmeübertragerelement 6 und dem zweiten plattenförmigen Wärmeübertragerelement 7 eine Fluidverbindung 10 gebildet ist, sodass das zweite plattenförmige Wärmeübertragerelement 7 mit dem Fluid aus dem ersten plattenförmigen Wärmeübertragerelement 6 durchströmbar ist. Der Einlass 8 und der Auslass 9 sind auf einer gemeinsamen Seite der Anordnung ausgebildet, sodass Wärme des am Auslass 9 aufgeheizten Fluids durch die Kontaktfläche zwischen dem ersten plattenförmigen Wärmeübertragerelement 6 und dem zweiten plattenförmigen Wärmeübertragerelement 7 an dass noch niedertemperiert einströmende Fluid ableitbar ist. Die Ableitung eines Teils der Wärme aus dem zweiten plattenförmigen Wärmeübertragerelement 7 an das erste plattenförmige Wärmeübertragerelement 6 ermöglicht eine Abkühlung des Fluids im zweiten plattenförmigen Wärmeübertragerelement 7, sodass entlang der Wärmeübertragungsfläche 12 ein geringerer Temperaturgradient erreicht werden kann.

Im Temperaturverlaufsdiagramm B ist der Temperaturverlauf im ersten plattenförmigen Wärmeübertragerelement 6 mit dem Anstieg 14 und der Temperaturverlauf im zweiten plattenförmigen Wärmeübertragerelement 7 mit dem Anstieg 15 dargestellt. Wie dem Anstieg 15 zu entnehmen ist, beträgt der Temperaturanstieg entlang der Wärmeübertragungsfläche 12 gegenüber der mit Figur 1 beschriebenen Konzeption bei gleichbleibender Fluidströmung lediglich 7,5 K. Die Temperaturdifferenz des Fluids zwischen dem Einlass 8 und dem Auslass 9 ergibt sich zu 15 K.

Im gezeigten Beispiel ist das Fluid im ersten plattenförmigen Wärmeübertragerelement 6 gegenüber der Fluidführung im zweiten plattenförmigen Wärmeübertragerelement 7 im Gegenstrom geführt.

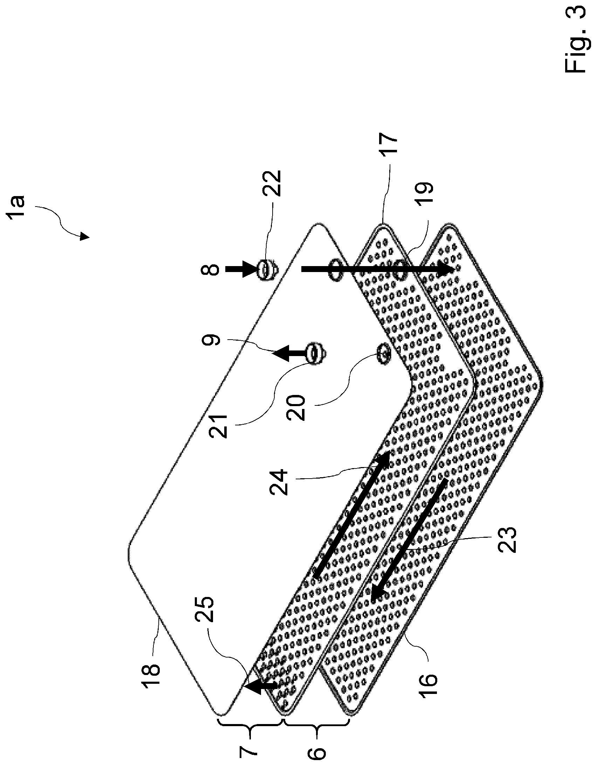

**Figur 3** zeigt die Vorrichtung 1a zur Wärmeübertragung aus Figur 2 in einer Explosionsdarstellung. Das erste plattenförmige Wärmeübertragerelement 6 und das zweite plattenförmige Wärmeübertragerelement 7 sind aus drei profilierten Platten 16, 17, 18 ausgebildet.

Dabei wird das erste plattenförmige Wärmeübertragerelement 6 von einer ersten Platten 16 und einer zweiten Platte 17 gebildet, wobei aufgrund einer Profilierung der Platten 16, 17 zwischen den Platten 16, 17 ein zusammenhängender Hohlraum gebildet ist, welcher eine gleichmäßige Fluidführung 23 des durch den Einlass 8 zugeführten Fluids durch das erste plattenförmige Wärmeübertragerelement 6 ermöglicht. Das zweite plattenförmige Wärmeübertragerelement 7 wird von der zweiten Platte 17 und einer dritten Platte 18 gebildet, wobei aufgrund einer Profilierung der Platten 17, 18 zwischen den Platten 17, 18 ein zusammenhängender Hohlraum gebildet ist, welcher eine gleichmäßige Fluidführung 24 durch das zweite plattenförmige Wärmeübertragerelement 7 hin zum Auslass 9 ermöglicht.

Um eine Durchführung des Fluids durch den Einlass 8 und das zweite plattenförmige Wärmeübertragerelement 7 hindurch in das erste plattenförmige Wärmeübertragerelement 6 zu gewährleisten, ist durch die zweite, mittlere Platte 17 und die dritte Platte 18 eine Durchgangsöffnung 19 gebildet, welche gegenüber der Fluidführung 24 des zweiten plattenförmigen Wärmeübertragerelements 7 mit einem Einlassstutzen 22 abgedichtet ist. Der Einlassstutzen 22 ist im zusammengefügten Zustand der Platten 16, 17, 18 in der Durchgangsöffnung 19 eingesteckt angeordnet.

Der Auslass 9 des Fluids ist mit einer Durchgangsöffnung 20 durch die dritte Platte 18 und einem Auslassstutzen 21 ausgebildet, wobei der Auslassstutzen 21 im zusammengefügten Zustand der Platten 16, 17, 18 in die Durchgangsöffnung 20 eingesteckt ist.

Durch eine zwischen dem ersten plattenförmigen Wärmeübertragerelement 6 und dem zweitem plattenförmigen Wärmeübertragerelement 7 ausgebildete Fluidverbindung 25 strömt das Fluid aus dem ersten plattenförmigen Wärmeübertragerelement 6 in das zweite plattenförmige Wärmeübertragerelement 7 über. Die Fluidverbindung 25 ist vorzugsweise als ein Schlitz ausgebildet, welcher sich über die gesamte Breite der Fluidführungen 23, 24 und damit der plattenförmigen Wärmeübertragerelemente 6, 7 erstreckt.

Die Fluidführungen 23, 24 kennzeichnen zudem jeweils die Strömungsrichtung des Fluids innerhalb der plattenförmigen Wärmeübertragerelemente 6, 7. Bei der Ausführungsform der Vorrichtung 1a aus Figur 3 wird das Fluid in der Fluidführung 23 durch das erste plattenförmige Wärmeübertragerelement 6 gegenüber der Fluidführung 24 im zweiten plattenförmigen Wärmeübertragerelement 7 im Gegenstrom geführt.

Figur 4a zeigt eine schematische Explosionsdarstellung einer Vorrichtung 1b zur Wärmeübertragung zum Temperieren einer Batterie 2 als ein Ausführungsbeispiel gemäß der Erfindung. Im Unterschied zu der in Figur 3 gezeigten Vorrichtung 1a sind die Fluidführung 26 durch das erste plattenförmige Wärmeübertragerelement 6 und die Fluidführung 27 durch das zweite plattenförmige Wärmeübertragerelement 7 der Vorrichtung 1b im Gleichstrom geführt. Die Fluidführungen 26, 27 sind jeweils in einer U-Form ausgebildet.

Das Fluid wird, wie schon bei der Ausführungsform nach Figur 3, durch den Einlass 8 und das zweite plattenförmige Wärmeübertragerelement 7 hindurch in das erste plattenförmige Wärmeübertragerelement 6 eingeleitet und strömt in der U-förmigen Fluidführung 26 durch das erste plattenförmige Wärmeübertragerelement 6. Mittels der Profilierung der Platten 16, 17 wird zwischen den Platten 16, 17 ein zusammenhängender Hohlraum gebildet, welcher im mittleren Bereich der Platten 16, 17 eine Trennwand ausbildet, welche sich in Längsrichtung der Platten 16, 17 erstreckt und an den längsseitigen Enden der Platten 16, 17 jeweils einen Überströmbereich für das Fluid vorsieht. Der Einlass 8 des Fluids in das erste plattenförmige Wärmeübertragerelement 6 und der Auslass des Fluids aus dem ersten plattenförmigen Wärmeübertragerelement 6 sind an einer gemeinsamen Schmalseite, voneinander getrennt und zueinander abgedichtet ausgebildet.

Durch eine zwischen dem ersten plattenförmigen Wärmeübertragerelement 6 und dem zweiten plattenförmigen Wärmeübertragerelement 7 ausgebildete Fluidverbindung 28 strömt das Fluid aus dem ersten plattenförmigen Wärmeübertragerelement 6 in das zweite plattenförmige Wärmeübertragerelement 7 über. Die Fluidverbindung 28 ist als Auslass des Fluids aus dem ersten plattenförmigen Wärmeübertragerelement 6 im Bereich des Einlasses 8 ausgebildet, sodass das Fluid in der U-förmigen Fluidführung 27 durch das zweite plattenförmige Wärmeübertragerelement 7 strömt, welche in Richtung und Ausmaß im Wesentlichen der U-förmigen Fluidführung 26 des ersten plattenförmigen Wärmeübertragerelements 6 entspricht. Mittels der Profilierung der Platten 17, 18 ist zwischen den Platten 17, 18 ebenfalls ein zusammenhängender Hohlraum gebildet, welcher im mittleren Bereich der Platten 17, 18 eine Trennwand ausbildet, welche sich in Längsrichtung der Platten 17, 18 erstreckt und an einem vom Einlass 8 und Auslass 9 abgewandten, längsseitigen Ende der Platten 17, 18 einen Überströmbereich für das Fluid vorsieht. Der Einlass des Fluids in das zweite plattenförmige Wärmeübertragerelement 7 und der Auslass 9 des Fluids aus der Vorrichtung 1b sind an einer gemeinsamen Schmalseite, voneinander getrennt und zueinander abgedichtet ausgebildet.

**Figur 4b** zeigt eine schematische Schnittdarstellung des Ausführungsbeispiels der Vorrichtung 1b zur Wärmeübertragung im zusammengesetzten Zustand. Die profilierten Platten 16, 17, 18 sind randseitig fluiddicht miteinander verbunden. Der Einlassstutzen 22 ist in der Durchgangsöffnung 19 eingesteckt angeordnet, sodass eine Fluidverbindung durch den Einlass 8 in das erste plattenförmige Wärmeübertragerelement 6 ausgebildet ist. Der Auslass 9 des Fluids ist mit einer Durchgangsöffnung 20 durch die dritte Platte 18 und einem Auslassstutzen 21 ausgebildet, wobei der Auslassstutzen 21 in die Durchgangsöffnung 20 eingesteckt angeordnet ist. Zwischen den profilierten Platten 16, 17, 18 sind durchgängige Hohlräume als Fluidführungen ausgebildet.

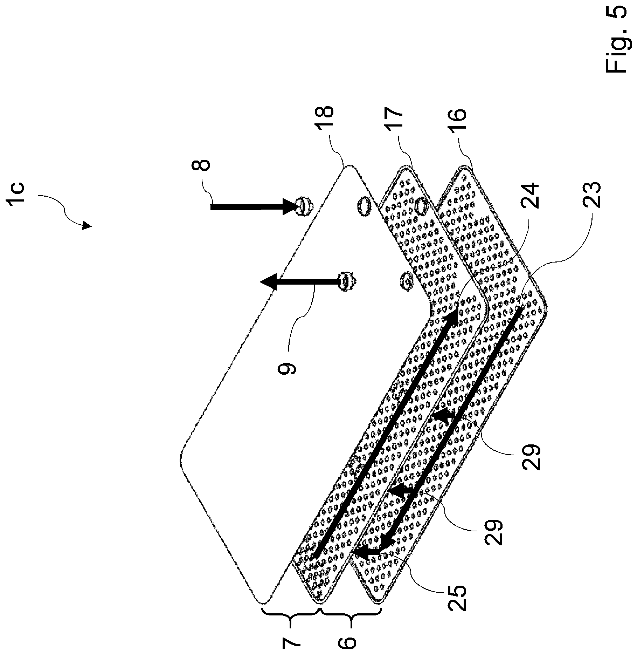

**Figur 5** zeigt eine Vorrichtung 1c zur Wärmeübertragung zum Temperieren einer Batterie 2.

Im Unterschied zu der in Figur 3 gezeigten Vorrichtung 1a sind entlang der Fluidführungen 23, 24 innerhalb der mittleren Platte 17 zwischen dem ersten plattenförmigen Wärmeübertragerelement 6 und dem zweiten plattenförmigen Wärmeübertragerelement 7 ein Vielzahl von zusätzlichen Fluidverbindungen 29 ausgebildet. Unter der Vielzahl wird dabei eine Anzahl von mindestens zwei verstanden. Die als Durchgangsöffnungen ausgebildeten und über die Fläche der Platte 17 verteilt angeordneten Fluidverbindungen 29 ermöglichen zusätzlich ein punktuelles Überströmen des Fluids aus dem ersten plattenförmigen Wärmeübertragerelement 6 in das zweite plattenförmige Wärmeübertragerelement 7.

Die drei profilierten Platten 16, 17, 18 der Vorrichtungen 1a, 1b, 1c sind entsprechend der Anforderungen jeweils derart dimensioniert, dass das Material und die Dicke der Platten 16, 17, 18 untereinander variieren können, um die erforderliche Wärme von einer Wärmequelle abzuleiten. Dabei kann sich insbesondere die zweite Platte 17, speziell in der Wandstärke, von der ersten Platte 16 und der dritten Platte 18 unterscheiden.

Zudem kann anstelle des zweiten plattenförmigen Wärmeübertragerelements 7 das erste plattenförmige Wärmeübertragerelement 6 der Vorrichtung 1a, 1b, 1c die Kontaktfläche zur flächigen Kontaktierung mit der Wärmeübertragungsfläche 12 der Batterie 2 aufweisen, sodass die Kontaktfläche auf der gegenüberliegenden Seite der Vorrichtung 1a, 1b, 1c ausgebildet ist.

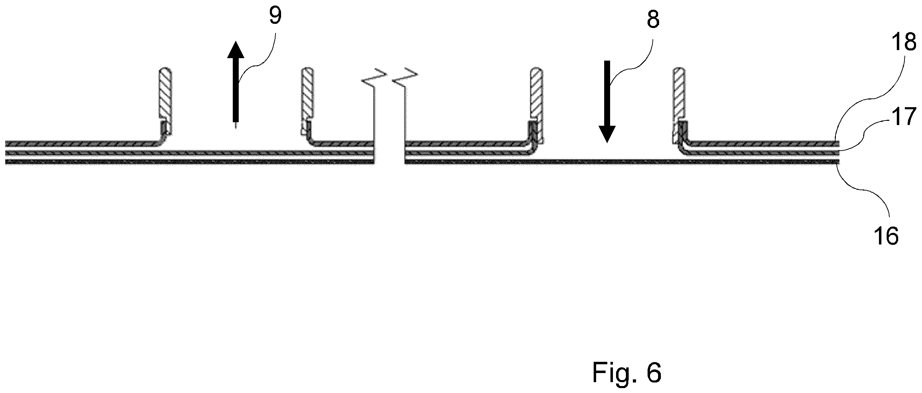

**Figur 6** zeigt eine schematische Schnittdarstellung einer Anordnung von Anschlüssen für den Einlass 8 und den Auslass 9 des Fluids. Die Verbindung zwischen den Platten 16, 17, 18, dem Einlassstutzen 22 und dem Auslassstutzen 21 kann durch Ineinanderstecken ausgebildet sein. Zudem können die Platten 16, 17, 18, der Einlassstutzen 22 und der Auslassstutzen 21 miteinander verlötet sein.

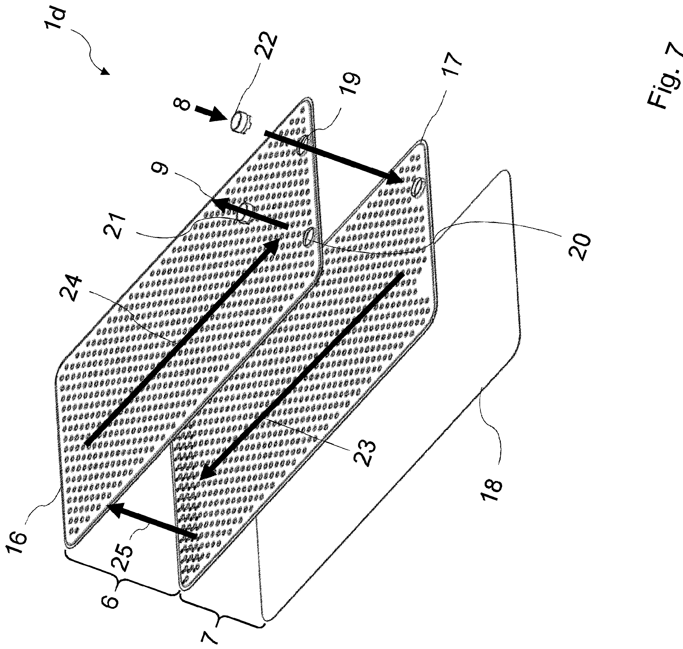

**Figur 7** zeigt eine Vorrichtung 1d als eine schematische Explosionsdarstellung, wobei der Einlass 8 und der Auslass 9 für das Fluid an einer von der Wärmeübertragungsfläche einer Batterie 2 und/oder eines Bauteils einer Leistungselektronik abgewandten Seite an dem ersten plattenförmigen Wärmeübertragerelement 6 angeordnet sind. Im Unterschied zu den Vorrichtungen 1a, 1b und 1c sind der Einlass 8 in der ersten Platte 16 sowie der zweiten Platte 17 und der Auslass 9 für das Fluid in der ersten Platte 16 ausgebildet. Dabei ist der Einlassstutzen 22 in der Durchgangsöffnung 19, welche in der ersten Platte 16 vorgesehen ist, eingesteckt angeordnet, sodass eine Fluidverbindung durch den Einlass 8 in das zweite plattenförmige Wärmeübertragerelement 7 ausgebildet ist. Der Auslass 9 des Fluids ist mit einer Durchgangsöffnung 20 durch die erste Platte 16 und einem Auslassstutzen 21 ausgebildet, wobei der Auslassstutzen 21 in die Durchgangsöffnung 20 eingesteckt angeordnet ist. Zwischen den profilierten Platten 16, 17, 18 sind durchgängige Hohlräume als Fluidführungen vorgesehen.

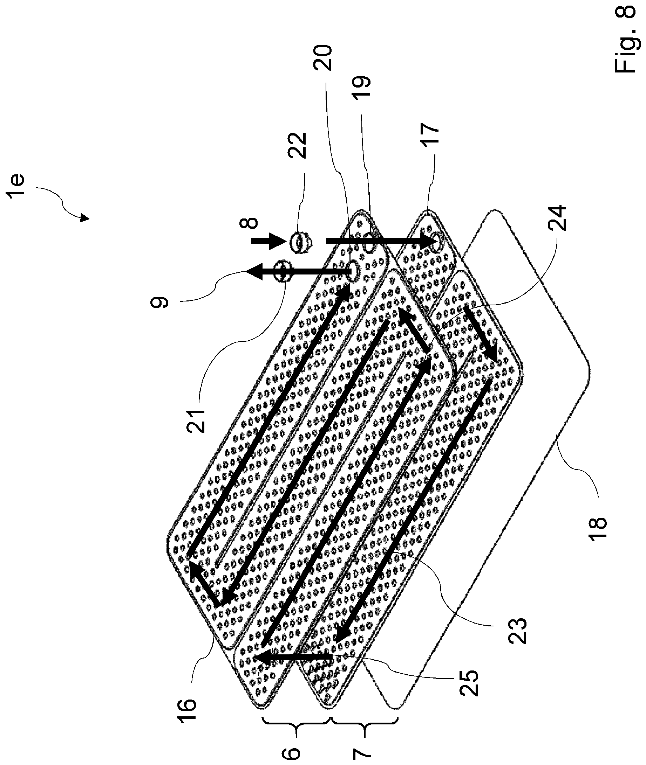

**Figur 8** zeigt eine Vorrichtung 1e als eine schematische Explosionsdarstellung eines Ausführungsbeispiels, wobei es sich um eine Weiterbildung der in Figur 7 gezeigten Vorrichtung 1d handelt. Der Einlass 8 und der Auslass 9 für das Fluid sind jeweils in einem Eckbereich der aus den Platten 16, 17, 18 ausgebildeten rechteckigen Wärmeübertrageranordnung angeordnet. Bei dieser Ausführungsform sind innerhalb der Wärmeübertragerelemente 6, 7 Fluidkanäle ausgebildet, welche den Strömungspfad für das Fluid in jedem der Wärmeübertragerelemente 6, 7 mindestens zweimal umlenken, sodass eine mäanderförmige oder zick-zack-förmige Fluidführung 23, 24 ausgebildet ist.

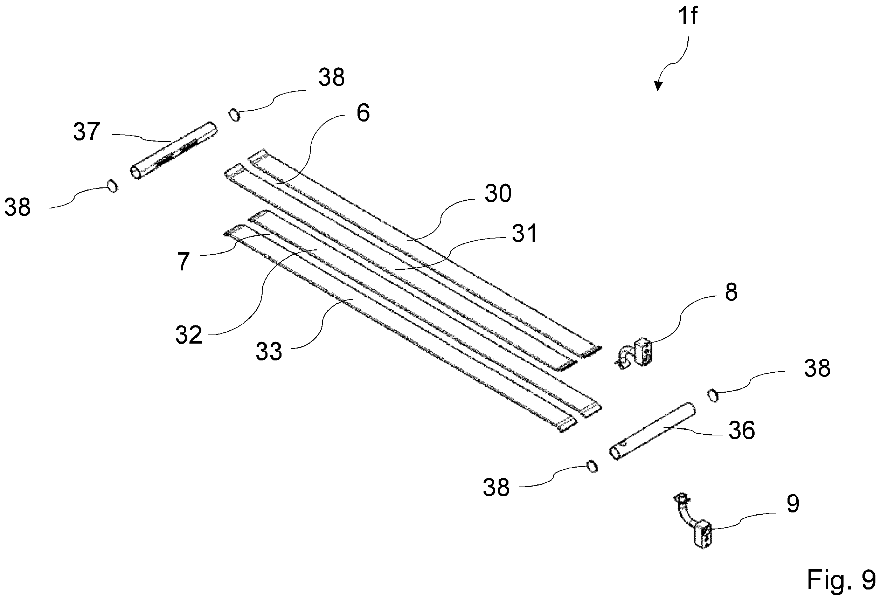

**Figur 9** zeigt eine schematische Explosionsdarstellung mit einer Vorrichtung 1f, bei welcher die Wärmeübertragerelemente 6, 7, im Unterschied zu den Vorrichtungen 1a bis 1e, aus jeweils zwei Flachrohren 30, 31, 32, 33 ausgebildet sind. Das Flachrohr 30 des aus den Flachrohren 30, 31 ausgebildeten ersten plattenförmigen Wärmeübertragerelements 6 und das Flachrohr 32 des aus den Flachrohren 32, 33 ausgebildeten zweiten plattenförmigen Wärmeübertragerelements 7 sind ebenso wie die Flachrohre 31, 33 der Wärmeübertragerelemente 6, 7 zur Wärmeübertragung jeweils flächig miteinander kontaktiert.

An den Enden sind die Flachrohre 30, 31, 32, 33 jeweils in einen rohrförmigen Sammler 36, 37 derart eingesteckt angeordnet, dass die inneren Volumina der Flachrohre 30, 31, 32, 33 und der Sammler 36, 37 miteinander verbunden sind. Der erste Sammler 36 weist zwei voneinander getrennte Kammern auf, wobei eine erste Kammer mit dem Einlass 8 verbunden ist, sodass durch den Einlass 8 zugeführtes Fluid zunächst in die erste Kammer einströmt. Ausgehend von der ersten Kammer strömt das Fluid durch zwei Flachrohre 30, 31 des ersten plattenförmigen Wärmeübertragerelements 6 zum zweiten Sammler 37, welcher lediglich eine Kammer aufweist, welche die inneren Volumina der Flachrohre 30, 31 des ersten plattenförmigen Wärmeübertragerelements 6 mit den inneren Volumina der Flachrohre 32, 33 des zweiten plattenförmigen Wärmeübertragerelements 7 verbindet, sodass das aus dem ersten plattenförmigen Wärmeübertragerelement 6 ausströmende Fluid in das zweite plattenförmige Wärmeübertragerelement 7 einströmt. Die Flachrohre 32, 33 des zweiten plattenförmigen Wärmeübertragerelements 7 münden in eine zweite Kammer des ersten Sammlers 36 ein, welche mit dem Auslass 9 verbunden ist. Die rohrförmigen Sammler 36, 37 sind seitlich jeweils mit Abschlusselementen 38 fluiddicht abgedichtet.

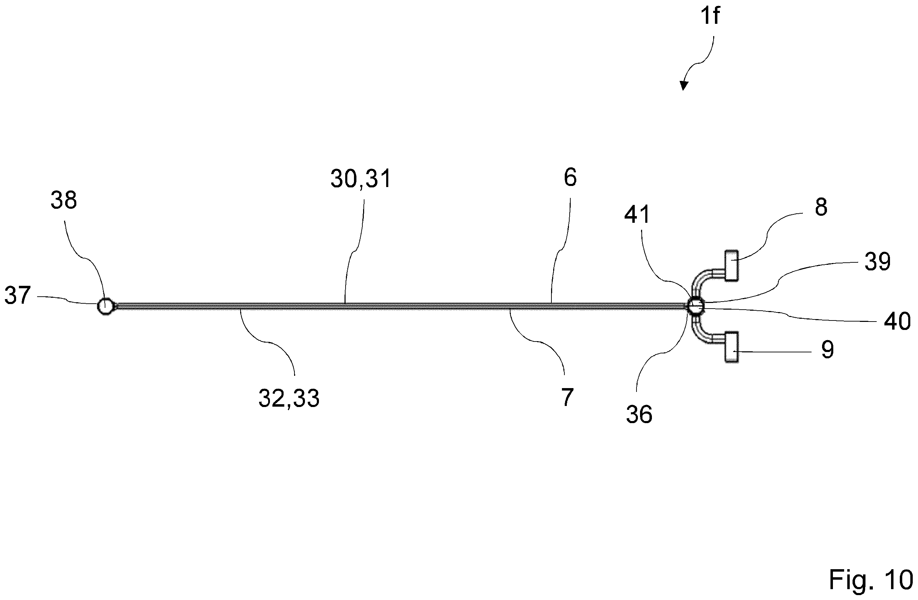

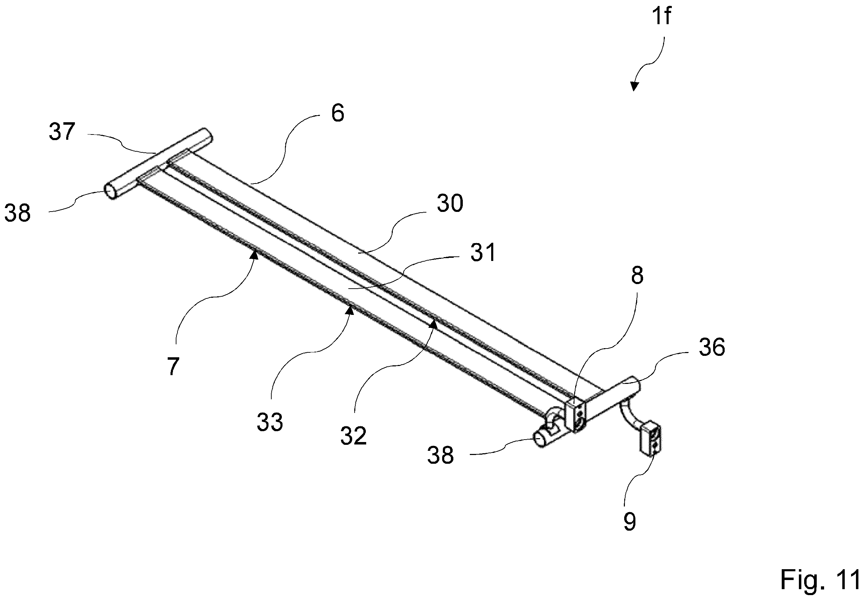

**Figur 10** zeigt eine schematische Darstellung einer Seitenansicht der in Figur 9 gezeigten Vorrichtung 1f in einem montierten Zustand. Aus **Figur 11** geht die in den Figuren 9 und 10 dargestellte Vorrichtung 1f in einer perspektivischen Darstellung hervor. Das erste plattenförmige Wärmeübertragerelement 6 und das zweite plattenförmige Wärmeübertragerelement 7, insbesondere entsprechend die Flachrohre 30, 31 des ersten plattenförmigen Wärmeübertragerelements 6 und die Flachrohre 32, 33 des zweiten plattenförmigen Wärmeübertragerelements 7, sind zur Wärmeübertragung flächig miteinander kontaktiert. Das zweite plattenförmige Wärmeübertragerelement 7 ist zudem zur flächigen Kontaktierung mit einer Wärmeübertragungsfläche einer Batterie 2 und/oder eines Bauteils einer Leistungselektronik ausgebildet. Der erste Sammler 36, hier an der Stirnseite ohne Abschlusselement 38 und damit geöffnet dargestellt, weist einerseits die erste Kammer 39 auf, welche den Einlass 8 und die inneren Volumina der Flachrohre 30, 31 des ersten plattenförmigen Wärmeübertragerelements 6 miteinander verbindet. Das durch den Einlass 8 in die Vorrichtung 1f zugeführte Fluid gelangt somit durch die Flachrohre 30, 31 des ersten plattenförmigen Wärmeübertragerelements 6 in den zweiten Sammler 37, in welchem die Strömungsrichtung des Fluids umgelenkt und das Fluid in die Flachrohre 32, 33 des zweiten plattenförmigen Wärmeübertragerelements 7 einströmt. Die in dem ersten Sammler 36 ausgebildete zweite Kammer 40 verbindet die Flachrohre 32, 33 des zweiten plattenförmigen Wärmeübertragerelements 7 mit dem Auslass 9, sodass Fluid durch die Flachrohre 32, 33 hindurch aus der Vorrichtung 1f abgeführt werden kann. Die Kammern 39, 40 sind durch ein Trennelement 41 voneinander getrennt.

Das Paar der flächig miteinander kontaktierten Flachrohre 30, 32 ist zu dem Paar der flächig miteinander kontaktierten Flachrohre 31, 33 beabstandet angeordnet.

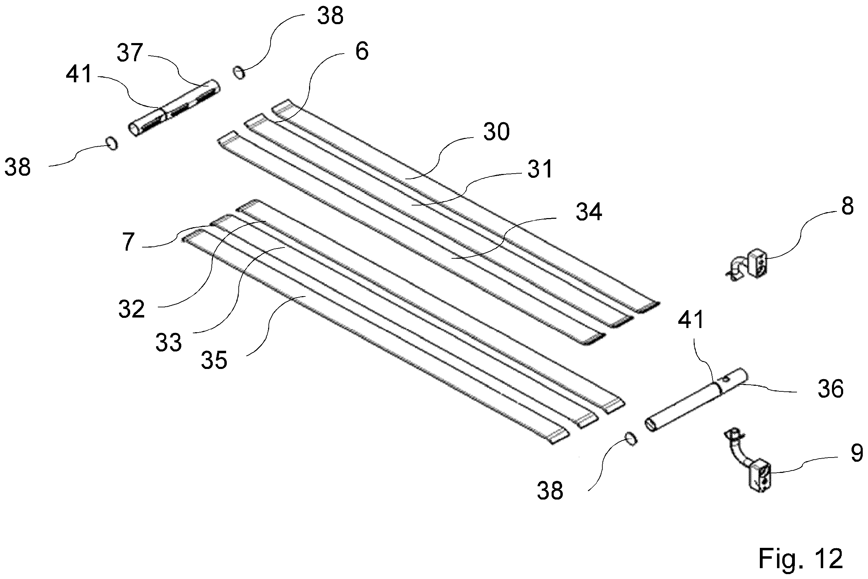

**Figur 12** zeigt eine schematische Explosionsdarstellung einer Weiterbildung der Vorrichtung 1f aus den Figuren 9, 10 oder 11. Bei der Ausführungsform nach Figur 12 sind die mindestens zwei fluidführenden plattenförmigen Wärmeübertragerelemente 6, 7 jeweils mit mindestens einem weiteren und damit dritten Flachrohr 34, 35 erweitert. Dabei sind der erste Sammler 36 und der zweite Sammler 37 beispielsweise entsprechend länger ausgebildet. Mittels im Inneren der Sammler 36, 37 angeordneter Trennelemente 41 werden fluiddichte Bereiche innerhalb der Sammler 36, 37 bereitgestellt, um einen gewünschten Strömungspfad für das Fluid auszubilden. Derart kann eine gleichläufige Strömung oder eine gegenläufige Strömung des Fluids durch die Flachrohre 30, 31, 32, 33, 34, 35 der plattenförmigen Wärmeübertragerelemente 6, 7 bereitgestellt werden.

### Bezugszeichenliste

- 1', 1a, 1b, 1c, 1d, 1e, 1f: Vorrichtung
- 2: Batterie
- 3: Einlass
- 4: Auslass
- 5: Wärmeübertrager
- 6: erstes plattenförmiges Wärmeübertragerelement
- 7: zweites plattenförmiges Wärmeübertragerelement
- 8: Einlass
- 9: Auslass
- 10: Fluidverbindung
- 11: Wärmeübertragungsfläche
- 12: Wärmeübertragungsfläche
- 13: Anstieg
- 14: Anstieg
- 15: Anstieg
- 16: erste Platte
- 17: zweite, mittlere Platte
- 18: dritte Platte
- 19: Durchgangsöffnung
- 20: Durchgangsöffnung
- 21: Auslassstutzen
- 22: Einlassstutzen
- 23, 24, 26, 27: Fluidführung
- 25: Fluidverbindung
- 28,29: Fluidverbindung
- 30, 31, 32, 33, 34, 35: Flachrohre
- 36: erster Sammler
- 37: zweiter Sammler
- 38: Abschlusselementen
- 39: erste Kammer
- 40: zweite Kammer
- 41: Trennelement

## Patentansprüche

1. Vorrichtung (1a, 1b, 1c, 1d, 1e, 1f) zur Wärmeübertragung zum Temperieren von Batterien und Bauteilen der Leistungselektronik, insbesondere für ein Elektrofahrzeug oder ein Hybridfahrzeug, aufweisend
einen Einlass (8) für ein Fluid und einen Auslass (9) für das Fluid, mindestens zwei fluidführende plattenförmige Wärmeübertragerelemente (6, 7), von welchen ein erstes plattenförmiges Wärmeübertragerelement (6) und ein zweites plattenförmiges Wärmeübertragerelement (7) zur Wärmeübertragung flächig miteinander kontaktiert sind, wobei das zweite plattenförmige Wärmeübertragerelement (7) zur flächigen Kontaktierung mit einer Wärmeübertragungsfläche einer Batterie (2) und/oder eines Bauteils einer Leistungselektronik ausgebildet ist, wobei
zwischen dem ersten plattenförmigen Wärmeübertragerelement (6) und dem zweiten plattenförmigen Wärmeübertragerelement (7) mindestens eine Fluidverbindung (10, 25, 29) ausgebildet ist, sodass das zweite plattenförmige Wärmeübertragerelement (7) mit dem aus dem ersten plattenförmigen Wärmeübertragerelement (6) austretenden Fluid durchströmbar ist, wobei das erste plattenförmige Wärmeübertragerelement (6) und das zweite plattenförmige Wärmeübertragerelement (7) aus drei profilierten Platten (16, 17, 18) ausgebildet sind, welche flächig zueinander angeordnet und zumindest randseitig fluiddicht miteinander verbunden sind, wobei Profilierungen der Platten (16, 17, 18) zwischen den Platten (16, 17, 18) Hohlräume als Fluidführungen (23, 24, 26, 27) ausbilden,
**dadurch gekennzeichnet, dass**
die Fluidverbindung (10, 25) zwischen den flächig kontaktierten plattenförmigen Wärmeübertragerelementen (6, 7) und Fluidführungen (26, 27) innerhalb der flächig kontaktierten plattenförmigen Wärmeübertragerelemente (6, 7) derart ausgebildet sind, dass das Fluid innerhalb der Fluidführung (26) des ersten plattenförmigen Wärmeübertragerelements (6) gegenüber der Fluidführung (27) im zweiten plattenförmigen Wärmeübertragerelement (7) im Gleichstrom geleitet wird.

2. Vorrichtung (1a, 1b, 1c, 1d, 1e) nach Anspruch 1, **dadurch gekennzeichnet, dass** der Einlass (8) für das Fluid an dem ersten plattenförmigen Wärmeübertragerelement (6) und der Auslass (9) für das Fluid an dem zweiten plattenförmigen Wärmeübertragerelement (7) ausgebildet sind.

3. Vorrichtung (1a, 1b, 1c, 1d, 1e) nach Anspruch 2, **dadurch gekennzeichnet, dass** der Einlass (8) des Fluids in das erste plattenförmige Wärmeübertragerelement (6) durch das zweite plattenförmige Wärmeübertragerelement (7) hindurchführend ausgebildet ist.

4. Vorrichtung (1a, 1b, 1c, 1d, 1e) nach einem der Ansprüche 1 bis 3, **dadurch gekennzeichnet, dass** der Einlass (8) des Fluids und der Auslass (9) des Fluids auf einer gemeinsamen Seite, insbesondere im Bereich einer Schmalseite, der flächig kontaktierten plattenförmigen Wärmeübertragerelemente (6, 7) angeordnet sind.

5. Vorrichtung (1a, 1b, 1c, 1d, 1e) nach einem der vorhergehenden Ansprüche, **dadurch gekennzeichnet, dass** das erste plattenförmige Wärmeübertragerelement (6) aus einer ersten Platte (16) und einer zweiten Platte (17) sowie das zweite plattenförmige Wärmeübertragerelement (7) aus der zweiten Platte (17) und einer dritten Platte (18) ausgebildet sind.

6. Vorrichtung (1a, 1b, 1c, 1d, 1e) nach einem der vorhergehenden Ansprüche, **dadurch gekennzeichnet, dass** die Fluidführungen (23, 24, 26, 27) im ersten plattenförmigen Wärmeübertragerelement (6) und im zweiten plattenförmigen Wärmeübertragerelement (7) jeweils als ein Kanal ausgebildet sind, welcher eine U-Form aufweist.

7. Vorrichtung (1a, 1b, 1c, 1d, 1e) nach einem der vorhergehenden Ansprüche, **dadurch gekennzeichnet, dass** die mindestens eine Fluidverbindung (25) zwischen den flächig kontaktierten plattenförmigen Wärmeübertragerelementen (6, 7) in Form eines Schlitzes auf den jeweils zugewandten Seiten zwischen den flächig kontaktierten plattenförmigen Wärmeübertragerelementen (6, 7) ausgebildet ist, wobei sich der Schlitz jeweils über die gesamte Breite einer Fluidführung (23, 24, 26, 27) erstreckt.

8. Vorrichtung (1a, 1b, 1c, 1d, 1e) nach Anspruch 7, **dadurch gekennzeichnet, dass** in der schlitzförmigen Fluidverbindung (25) mindestens ein Drosselelement angeordnet ist.

9. Vorrichtung (1c) nach einem der Ansprüche 1 bis 8, **dadurch gekennzeichnet, dass** über die gemeinsame Kontaktfläche zwischen dem ersten plattenförmigen Wärmeübertragerelement (6) und dem zweiten plattenförmigen Wärmeübertragerelement (7) mehrere Fluidverbindungen (29) derart verteilt angeordnet sind, dass das Fluid durch die Fluidverbindungen (29) hindurch aus dem ersten plattenförmigen Wärmeübertragerelement (6) punktuell in das zweite plattenförmige Wärmeübertragerelement (7) überströmt.

10. Vorrichtung (1a, 1b, 1c, 1d, 1e) nach einem der vorhergehenden Ansprüche, **dadurch gekennzeichnet, dass** die Fluidführung (23, 26) im ersten plattenförmigen Wärmeübertragerelement (6) mit Turbulatoren und/oder Leitelementen derart ausgebildet ist, dass im ersten plattenförmigen Wärmeübertragerelement (6) eine gleichmäßige Verteilung des Fluids gewährleistet ist.

11. Vorrichtung (1a, 1b, 1c, 1d, 1e) nach einem der vorhergehenden Ansprüche, **dadurch gekennzeichnet, dass** die Fluidführung (24, 27) im zweiten plattenförmigen Wärmeübertragerelement (7) mit Turbulatoren und/oder Leitelementen derart ausgebildet ist, dass im zweiten plattenförmigen Wärmeübertragerelement (7) eine gleichmäßige Verteilung des Fluids gewährleistet ist.

12. Vorrichtung (1a, 1b, 1c, 1d, 1e) nach einem der Ansprüche 1 bis 11, **dadurch gekennzeichnet, dass** das zweite plattenförmige Wärmeübertragerelement (7) durch Kleben, Verpressen, Löten oder Sintern mit der Wärmeübertragungsfläche einer Batterie (2) und/oder eines Bauteils einer Leistungselektronik ausgebildet ist.

13. Vorrichtung (1a, 1b, 1c) nach einem der Ansprüche 1 bis 12, **dadurch gekennzeichnet, dass** der Einlass (8) und der Auslass (9) für das Fluid an einer Kontaktseite mit der Wärmeübertragungsfläche einer Batterie (2) und/oder eines Bauteils einer Leistungselektronik an dem zweiten plattenförmigen Wärmeübertragerelement (7) angeordnet sind.

14. Vorrichtung (1d, 1e) nach einem der Ansprüche 1 bis 12, **dadurch gekennzeichnet, dass** der Einlass (8) und der Auslass (9) für das Fluid an einer von der Wärmeübertragungsfläche einer Batterie (2) und/oder eines Bauteils einer Leistungselektronik abgewandten Seite an dem ersten plattenförmigen Wärmeübertragerelement (6) angeordnet sind.

15. Vorrichtung (1a, 1b, 1c, 1d, 1e) nach einem der Ansprüche 1 bis 14, **dadurch gekennzeichnet, dass** die Fluidführungen (23, 24, 26, 27) im ersten plattenförmigen Wärmeübertragerelement (6) und im zweiten plattenförmigen Wärmeübertragerelement (7) jeweils als ein Kanal ausgebildet sind, welcher eine Zick-Zack-Form aufweist.

## Claims

1. Heat transfer device (1a, 1b, 1c, 1d, 1e, 1f) for controlling the temperature of batteries and power electronics components, in particular for an electric vehicle or a hybrid vehicle, having an inlet (8) for a fluid and an outlet (9) for the fluid, at least two fluid-conducting plate-formed heat exchanger elements (6, 7), of which a first plate-formed heat exchanger element (6) and a second plate-formed heat exchanger element (7) are placed in planar contact with each other in order to transfer heat, wherein the second plate-formed heat exchanger element (7) is designed to make planar contact with a heat transfer surface of a battery (2) and/or of a power electronics component, wherein at least one fluid connection (10, 25, 29) is formed between the first plate-formed heat exchanger element (6) and the second plate-formed heat exchanger element (7) so that the second plate-formed heat exchanger element (7) can be flowed through by the fluid issuing from the first plate-formed heat exchanger element (6), wherein the first plate-formed heat exchanger element (6) and the second plate-formed heat exchanger element (7) are formed from three profiled plates (16, 17, 18) which are arranged in a planar manner relative to each other and are, at least at the edges, connected to each other in a fluid-tight manner, wherein profilings of the plates (16, 17, 18) form cavities between the plates (16, 17, 18) acting as fluid passages (23, 24, 26, 27), **characterised in that**
the fluid connection (10, 25) between the planar-contacted plate-formed heat exchanger elements (6, 7) and fluid passages (26, 27) within the planar-contacted plate-formed heat exchanger elements (6, 7) are formed in such a way that the fluid within the fluid passage (26) of the first plate-formed heat exchanger element (6) is channelled in the same direction of flow as in the fluid passage (27) in the second plate-formed heat exchanger element (7).

2. Device (1a, 1b, 1c, 1d, 1e) according to claim 1, **characterised in that** the inlet (8) for the fluid is formed on the first plate-formed heat exchanger element (6) and the outlet (9) for the fluid is formed on the second plate-formed heat exchanger element (7).

3. Device (1a, 1b, 1c, 1d, 1e) according to claim 2, **characterised in that** the inlet (8) for the fluid into the first plate-formed heat exchanger element (6) is designed to pass through the second plate-formed heat exchanger element (7).

4. Device (1a, 1b, 1c, 1d, 1e) according to one of the claims 1 to 3, **characterised in that** the inlet (8) for the fluid and the outlet (9) for the fluid are arranged on a common side, in particular in the region of a narrow side of the planar-contacted plate-formed heat exchanger elements (6, 7).

5. Device (1a, 1b, 1c, 1d, 1e) according to one of the preceding claims, **characterised in that** the first plate-formed heat exchanger element (6) is formed from a first plate (16) and a second plate (17) and the second plate-formed heat exchanger element (7) is formed from the second plate (17) and a third plate (18).

6. Device (1a, 1b, 1c, 1d, 1e) according to one of the preceding claims, **characterised in that** the fluid passages (23, 24, 26, 27) in the first plate-formed heat exchanger element (6) and in the second plate-formed heat exchanger element (7) are in each case formed as a channel having a U-shape.

7. Device (1a, 1b, 1c, 1d, 1e) according to one of the preceding claims, **characterised in that** the at least one fluid connection (25) between the planar-contacted plate-formed heat exchanger elements (6, 7) is in the form of a slot on the respective facing sides between the planar-contacted plate-formed heat exchanger elements (6, 7), wherein the slot extends over the entire width of a fluid passage (23, 24, 26, 27).

8. Device (1a, 1b, 1c, 1d, 1e) according to claim 7, **characterised in that** at least one throttle element is arranged in the slot-shaped fluid connection (25).

9. Device (1c) according to one of the claims 1 to 8, **characterised in that** a plurality of fluid connections (29) are arranged distributed over the common contact surface between the first plate-formed heat exchanger element (6) and the second plate-formed heat exchanger element (7) in such a way that the fluid flows across from the first plate-formed heat exchanger element (6) into the second plate-formed heat exchanger element (7) at individual points through the fluid connections (29).

10. Device (1a, 1b, 1c, 1d, 1e) according to one of the preceding claims, **characterised in that** the fluid passage (23, 26) in the first plate-formed heat exchanger element (6) is designed with turbulators and/or guide elements in such a way that an even distribution of the fluid is guaranteed in the first plate-plate heat formed exchanger element (6).

11. Device (1a, 1b, 1c, 1d, 1e) according to one of the preceding claims, **characterised in that** the fluid passage (24, 27) in the second plate-formed heat exchanger element (7) is designed with turbulators and/or guide elements in such a way that an even distribution of the fluid is guaranteed in the second plate-plate heat formed exchanger element (7).

12. Device (1a, 1b, 1c, 1d, 1e) according to one of the claims 1 to 11, **characterised in that** the second plate-formed heat exchanger element (7) is formed by adhesive bonding, pressing, soldering or sintering with the heat transfer surface of a battery (2) and/or a power electronics component.

13. Device (1a, 1b, 1c) according to one of the claims 1 to 12, **characterised in that** the inlet (8) and the outlet (9) for the fluid are arranged on the second plate-formed heat exchanger element (7) on a contact side with the heat transfer surface of a battery (2) and/or a power electronics component.

14. Device (1d, 1e) according to one of the claims 1 to 12, **characterised in that** the inlet (8) and the outlet (9) for the fluid are arranged on the first plate-formed heat exchanger element (6) on a side facing away from the heat transfer surface of a battery (2) and/or a power electronics component.

15. Device (1a, 1b, 1c, 1d, 1e) according to one of the claims 1 to 14, **characterised in that** the fluid passages (23, 24, 26, 27) in the first plate-formed heat exchanger element (6) and in the second plate-formed heat exchanger element (7) are in each case designed in the form of a channel having a zigzag shape.

## Revendications

1. Dispositif (1a, 1b, 1c, 1d, 1e, 1f) pour la transmission de chaleur destiné à la mise en température de batteries et de composants de l'électronique de puissance, en particulier pour un véhicule électrique ou un véhicule hybride, présentant
une entrée (8) pour un fluide et une sortie (9) pour le fluide,
au moins deux éléments de transmission de chaleur (6, 7) en forme de plaque acheminant du fluide, parmi lesquels un premier élément de transmission de chaleur (6) en forme de plaque et un second élément de transmission de chaleur (7) en forme de plaque pour la transmission de chaleur sont en contact de manière plane l'un avec l'autre, dans lequel le second élément de transmission de chaleur (7) en forme de plaque est réalisé pour la mise en contact plane avec une surface de transmission de chaleur d'une batterie (2) et/ou d'un composant d'une électronique de puissance, dans lequel
au moins une liaison fluidique (10, 25, 29) est réalisée entre le premier élément de transmission de chaleur (6) en forme de plaque et le second élément de transmission de chaleur (7) en forme de plaque de sorte que le second élément de transmission de chaleur (7) en forme de plaque puisse être traversé par le fluide sortant du premier élément de transmission de chaleur (6) en forme de plaque, dans lequel le premier élément de transmission de chaleur (6) en forme de plaque et le second élément de transmission de chaleur (7) en forme de plaque sont réalisés à partir de trois plaques profilées (16, 17, 18) qui sont agencées de manière plane les unes par rapport aux autres et sont reliées au moins côté bord de manière étanche au fluide les unes avec les autres, dans lequel des profilages des plaques (16, 17, 18) entre les plaques (16, 17, 18) réalisent des espaces creux comme guidages fluidiques (23, 24, 26, 27),
**caractérisé en ce que**
la liaison fluidique (10, 25) est réalisée entre les éléments de transmission de chaleur (6, 7) en forme de plaque en contact de manière plane et les guidages fluidiques (26, 27) à l'intérieur des éléments de transmission de chaleur (6, 7) en forme de plaque en contact de manière plane de telle manière que le fluide à l'intérieur du guidage fluidique (26) du premier élément de transmission de chaleur (6) en forme de plaque soit mené par rapport au guidage fluidique (27) dans le second élément de transmission de chaleur (7) en forme de plaque dans un écoulement de même sens.

2. Dispositif (1a, 1b, 1c, 1d, 1e) selon la revendication 1, **caractérisé en ce que** l'entrée (8) pour le fluide est réalisée au niveau du premier élément de transmission de chaleur (6) en forme de plaque et la sortie (9) pour le fluide est réalisée au niveau du second élément de transmission de chaleur (7) en forme de plaque.

3. Dispositif (1a, 1b, 1c, 1d, 1e) selon la revendication 2, **caractérisé en ce que** l'entrée (8) du fluide dans le premier élément de transmission de chaleur (6) en forme de plaque est réalisée de manière à traverser le second élément de transmission de chaleur (7) en forme de plaque.

4. Dispositif (1a, 1b, 1c, 1d, 1e) selon l'une quelconque des revendications 1 à 3, **caractérisé en ce que** l'entrée (8) du fluide et la sortie (9) du fluide sont agencées sur un côté commun, en particulier dans la zone d'un côté étroit, des éléments de transmission de chaleur (6, 7) en forme de plaque en contact de manière plane.

5. Dispositif (1a, 1b, 1c, 1d, 1e) selon l'une quelconque des revendications précédentes, **caractérisé en ce que** le premier élément de transmission de chaleur (6) en forme de plaque est réalisé à partir d'une première plaque (16) et d'une deuxième plaque (17) ainsi que le second élément de transmission de chaleur (7) en forme de plaque est réalisé à partir de la deuxième plaque (17) et d'une troisième plaque (18).

6. Dispositif (1a, 1b, 1c, 1d, 1e) selon l'une quelconque des revendications précédentes, **caractérisé en ce que** les guidages fluidiques (23, 24, 26, 27) sont réalisés dans le premier élément de transmission de chaleur (6) en forme de plaque et dans le second élément de transmission de chaleur (7) en forme de plaque respectivement comme un canal qui présente une forme de U.

7. Dispositif (1a, 1b, 1c, 1d, 1e) selon l'une quelconque des revendications précédentes, **caractérisé en ce que** l'au moins une liaison fluidique (25) est réalisée entre les éléments de transmission de chaleur (6, 7) en forme de plaque en contact de manière plane sous la forme d'une fente sur les côtés tournés respectivement entre les éléments de transmission de chaleur (6, 7) en forme de plaque en contact de manière plane, dans lequel la fente s'étend respectivement sur la largeur entière d'un guidage fluidique (23, 24, 26, 27).

8. Dispositif (1a, 1b, 1c, 1d, 1e) selon la revendication 7, **caractérisé en ce qu'au** moins un élément d'étranglement est agencé dans la liaison fluidique (25) en forme de fente.

9. Dispositif (1c) selon l'une quelconque des revendications 1 à 8, **caractérisé en ce que** plusieurs liaisons fluidiques (29) sont agencées en étant réparties sur la surface de contact commune entre le premier élément de transmission de chaleur (6) en forme de plaque et le second élément de transmission de chaleur (7) en forme de plaque de telle manière que le fluide passe à travers les liaisons fluidiques (29) à partir du premier élément de transmission de chaleur (6) en forme de plaque ponctuellement dans le second élément de transmission de chaleur (7) en forme de plaque.

10. Dispositif (1a, 1b, 1c, 1d, 1e) selon l'une quelconque des revendications précédentes, **caractérisé en ce que** le guidage fluidique (23, 26) est réalisé dans le premier élément de transmission de chaleur (6) en forme de plaque avec des turbulateurs et/ou des éléments de conduite de telle manière qu'une répartition uniforme du fluide soit garantie dans le premier élément de transmission de chaleur (6) en forme de plaque.

11. Dispositif (1a, 1b, 1c, 1d, 1e) selon l'une quelconque des revendications précédentes, **caractérisé en ce que** le guidage fluidique (24, 27) est réalisé dans le second élément de transmission de chaleur (7) en forme de plaque avec des turbulateurs et/ou des éléments de conduite de telle manière qu'une répartition uniforme du fluide soit garantie dans le second élément de transmission de chaleur (7) en forme de plaque.

12. Dispositif (1a, 1b, 1c, 1d, 1e) selon l'une quelconque des revendications 1 à 11, **caractérisé en ce que** le second élément de transmission de chaleur (7) en forme de plaque est réalisé par collage, pressage, brasage ou frittage avec la surface de transmission de chaleur d'une batterie (2) et/ou d'un composant d'une électronique de puissance.

13. Dispositif (1a, 1b, 1c) selon l'une quelconque des revendications 1 à 12, **caractérisé en ce que** l'entrée (8) et la sortie (9) pour le fluide sont agencées au niveau d'un côté de contact avec la surface de transmission de chaleur d'une batterie (2) et/ou d'un composant d'une électronique de puissance au niveau du second élément de transmission de chaleur (7) en forme de plaque.

14. Dispositif (1d, 1e) selon l'une quelconque des revendications 1 à 12, **caractérisé en ce que** l'entrée (8) et la sortie (9) pour le fluide sont agencées au niveau d'un côté éloigné de la surface de transmission de chaleur d'une batterie (2) et/ou d'un composant d'une électronique de puissance au niveau du premier élément de transmission de chaleur (6) en forme de plaque.

15. Dispositif (1a, 1b, 1c, 1d, 1e) selon l'une quelconque des revendications 1 à 14, **caractérisé en ce que** les guidages fluidiques (23, 24, 26, 27) sont réalisés dans le premier élément de transmission de chaleur (6) en forme de plaque et dans le second élément de transmission de chaleur (7) en forme de plaque respectivement comme un canal qui présente une forme de zigzag.
